# EUROPEAN PATENT APPLICATION

(11) **EP 4 770 377 A1**
(43) Date of publication of application: **01.07.2026**
(21) Application number: 24936350.8
(22) Date of filing: 25.04.2024
(51) Int. Cl.: H10K 59/131, G09G 3/32

(54) **DISPLAY PANEL AND DISPLAY DEVICE**

(71) Applicant: BOE TECHNOLOGY GROUP CO., LTD., Beijing 100015 (CN); Beijing BOE Technology Development Co., Ltd., Daxing District Beijing 100176 (CN)
(72) Inventor: HAN, Ying, Daxing District, Beijing 100176 (CN); XU, Pan, Daxing District, Beijing 100176 (CN); LV, Guangshuang, Daxing District, Beijing 100176 (CN); ZHAO, Donghui, Daxing District, Beijing 100176 (CN); ZHANG, Xing, Daxing District, Beijing 100176 (CN); LUO, Chengyuan, Daxing District, Beijing 100176 (CN)
(74) Representative: Brötz, Helmut
(86) International application number: PCT/CN2024/089800
(87) International publication number: WO 2025/222437

(57) **Abstract**

Provided are a display panel and a display device. The display panel comprises: a plurality of sub-pixels, wherein at least one of the plurality of sub-pixels comprises a pixel circuit and a light-emitting element, the pixel circuit comprises a first transistor, a second transistor, and a third transistor, a first electrode of the second transistor is connected to a gate of the first transistor, and a first electrode of the third transistor is connected to a first electrode of the first transistor; first gate lines connected to a gate of the second transistor; and second gate lines connected to a gate of the third transistor, wherein the first gate lines extend in a first direction, the second gate lines extend in the first direction, the first gate lines and the second gate lines are arranged at intervals in a second direction, and the first direction intersects the second direction, so as to facilitate structural arrangement of pixel circuits, layout design, increase of an aperture ratio, and improvement of a display effect.

## Description

### TECHNICAL FIELD

At least one embodiment of the present disclosure relates to a display panel and a display apparatus.

### BACKGROUND

White organic light-emitting diode (WOLED) products utilize white light sources to realize color adjustment via color filter layers. Red, green and blue organic light-emitting diodes (RGB OLED) products that emit color light directly realize direct light emission using various color light sources.

Compared with top-emission WOLED products, bottom-emission WOLED products are low in cathode sheet resistance, do not need complicated auxiliary cathode processes, and have high productivity. Moreover, compared with the RGB OLED products that emit color light directly, the WOLED products have the advantage of low power consumption. However, for each pixel, as the number of sub-pixels increases by one, pixel layout of WOLED products with the same resolution is limited in space and is more difficult to manufacture, openings between the sub-pixels have small spacing, and the risk of light leakage is higher.

### SUMMARY

At least one embodiment of the present disclosure relates to a display panel and a display apparatus, for facilitating structural arrangement of pixel circuits and layout design to increase the aperture ratio and improve the display effect.

At least one embodiment of the present disclosure provides a display panel, including: a plurality of sub-pixels, at least one sub-pixel of the plurality of sub-pixels including a pixel circuit and a light-emitting element, the pixel circuit including a first transistor, a second transistor and a third transistor, a first electrode of the second transistor being connected to a gate electrode of the first transistor, and a first electrode of the third transistor being connected to a first electrode of the first transistor; a first gate line connected to a gate electrode of the second transistor; and a second gate line connected to a gate electrode of the third transistor; the first gate line extends in a first direction, the second gate line extends in the first direction, the first gate line and the second gate line are spaced apart from each other in a second direction, and the first direction intersects the second direction.

For example, the first gate line and the second gate line connected to the second transistor and the third transistor of the same sub-pixel respectively are different gate lines.

For example, a plurality of first gate lines are provided, a plurality of second gate lines are provided, and the plurality of first gate lines and the plurality of first gate lines are arranged alternately in the second direction.

For example, the third transistor is closer to the first transistor than the second transistor in the same sub-pixel.

For example, the plurality of sub-pixels include a plurality of pixel groups, each pixel group of the plurality of pixel groups includes two rows and two columns of a total of four sub-pixels, the same first gate line is connected to each of two second transistors in the two rows of sub-pixels, and the four sub-pixels in the same pixel group are in symmetrical arrangement in layout.

For example, the pixel circuits at the positions of the four sub-pixels in the same pixel group are in symmetrical arrangement relative to a first axis parallel with the first direction and are in symmetrical arrangement relative to a second axis parallel with the second direction.

For example, two second transistors in the two rows of sub-pixels connected to the same first gate line are arranged in the first direction.

For example, a center connecting line of active layers of the first transistor, the second transistor and the third transistor in each of two sub-pixels of four sub-pixels in the same pixel group forms an obtuse triangle.

For example, two second transistors in the two rows of sub-pixels connected to the same first gate line are arranged in the second direction.

For example, a center connecting line of active layers of the first transistor, the second transistor, and the third transistor in each of four sub-pixels in the same pixel group forms an obtuse triangle.

For example, the four sub-pixels include a first sub-pixel, a second sub-pixel, a third sub-pixel, and a fourth sub-pixel, the first sub-pixel and the third sub-pixel are arranged in the first direction, the fourth sub-pixel and the second sub-pixel are arranged in the first direction, the first sub-pixel and the fourth sub-pixel are arranged in the second direction, and the third sub-pixel and the second sub-pixel are arranged in the second direction.

For example, the first sub-pixel is a red sub-pixel, the second sub-pixel is a green sub-pixel, the third sub-pixel is a blue sub-pixel, and the fourth sub-pixel is a white sub-pixel.

For example, the display panel further includes a data line, a first power line and a sense line, the data line is connected to a second electrode of the second transistor, the first power line is connected to a second electrode of the first transistor, the sense line is connected to the second electrode of the third transistor, and the data line, the first power line, and the sense line all extend in the second direction.

For example, a plurality of data lines are provided and include a first data line, a second data line, a third data line and a fourth data line, the first data line is connected to the second transistor of the first sub-pixel, the second data line is connected to the second transistor of the second sub-pixel, the third data line is connected to the second transistor of the third sub-pixel, and the fourth data line is connected to the second transistor of the fourth sub-pixel.

For example, the fourth data line, the first data line, the second data line and the third data line are arranged in the first direction, the sense line is disposed between the first data line and the second data line, and the first data line, the sense line, and the second data line are located between pixel openings of two adjacent columns of sub-pixels.

For example, the fourth data line and the third data line are adjacent to two first power lines respectively, the fourth data line and the first power line adjacent thereto are located between pixel openings of two adjacent columns of sub-pixels, the third data line and the first power line adjacent thereto are located between pixel openings of two adjacent columns of sub-pixels, thus forming a structure in which one first power line, one fourth data line, one column of pixel openings, one first data line, one sense line, one second data line, another column of pixel openings, one third data line, and the other first power line are sequentially arranged in the first direction.

For example, the plurality of data lines are not overlapped with one another.

For example, the first power line and the sense line are located between pixel openings of two adjacent columns of sub-pixels, the first data line and the fourth data line are located between pixel openings of two adjacent columns of sub-pixels, the third data line and the second data line are located between pixel openings of two adjacent columns of sub-pixels, thus forming a structure in which the first data line, the fourth data line, a column of pixel openings, the first power line, the sense line, another column of pixel openings, the third data line, and the second data line are sequentially arranged in the first direction.

For example, two signal lines extending in the second direction are disposed between pixel openings of every two adjacent columns of sub-pixels.

For example, the first power line includes a power body line and a power connection line, the power body line extends in the second direction, the power connection line extends in the first direction, and the power connection line is located between the second gate line and the active layer of the first transistor.

For example, the power connection line, the first gate line, and the second gate line are located in the same layer.

For example, the light-emitting element is connected to the pixel circuit through a via hole, and the via hole is closer to the first gate line than the active layer of the first transistor in the same sub-pixel.

For example, the second gate line includes a gate body line and a branch, the gate body line extends in the first direction, the branch extends in the second direction, the gate body line and the branch are of an integral structure, and the branch serves as the gate electrode of the third transistor.

For example, the display panel further includes a light shield layer, the light shield layer is overlapped with the first transistor.

For example, the pixel circuit further includes a storage capacitor, the storage capacitor includes a first electrode plate and a second electrode plate, the first electrode plate is connected to the gate electrode of the first transistor, the second electrode plate is connected to the first electrode of the first transistor, the first electrode of the third transistor, and a first electrode of the light-emitting element, respectively, and the second electrode plate is connected to the light shield layer.

For example, the display panel further includes a color filter layer, the color filter layer is located between the light-emitting element and the pixel circuit, the color filter layer includes an opening, and the light-emitting element passes through the opening of the color filter layer to be connected to the pixel circuit.

At least one embodiment of the present disclosure provides a display apparatus, including any one of the display panels as described above.

### BRIEF DESCRIPTION OF DRAWINGS

In order to more clearly illustrate the technical solution of the embodiments of the present disclosure, the drawings of the embodiments will be briefly described in the following. Apparently, the described drawings in the following are only related to some embodiments of the present disclosure without any limitation to the present disclosure.
Fig. 1 is a schematic diagram of pixel arrangement in a strip form.
Fig. 2 is a schematic diagram of pixel arrangement in a square form.
Fig. 3A is a schematic diagram of a 3T1C pixel circuit in a display panel provided by an embodiment of the present disclosure.
Fig. 3B is signal timing diagram of the pixel circuit during a display process.
Fig. 3C and Fig. 3D are signal timing diagrams of the pixel circuit during a detection process.
Fig. 4 is a layout diagram of a display panel provided by an embodiment of the present disclosure.
Fig. 5 is a layout diagram of a display panel provided by an embodiment of the present disclosure.
Fig. 6 to Fig. 14 are plan views of single layers of a display panel provided by an embodiment of the present disclosure.
Fig. 15 is a cross-sectional view of a display panel provided by an embodiment of the present disclosure.
Fig. 16 is a layout diagram of a display panel provided by another embodiment of the present disclosure.
Fig. 17 is a layout diagram of a display panel provided by another embodiment of the present disclosure.
Fig. 18 is a layout diagram of a display panel provided by another embodiment of the present disclosure.

### DETAILED DESCRIPTION

In order to make objectives, technical details, and advantages of the embodiments of the present disclosure more clearly, the technical solutions of the embodiments will be described in a clearly and fully understandable way in connection with the drawings related to the embodiments of the present disclosure. Apparently, the described embodiments are just a part but not all of the embodiments of the present disclosure. Based on the described embodiments herein, those skilled in the art can obtain other embodiment(s), without any inventive work, which should be within the scope of the present disclosure.

Unless otherwise defined, all the technical and scientific terms used herein have the same meanings as commonly understood by one of ordinary skill in the art to which the present disclosure belongs. The terms "first," "second," etc., which are used in the present disclosure, are not intended to indicate any sequence, amount or importance, but distinguish various components. Also, the words such as "a", "an" or "the" do not indicate a quantity limit, but indicate the existence of at least one. The terms "comprise," "comprising," "include," "including," etc., are intended to specify that the elements or the objects stated before these terms encompass the elements or the objects and equivalents thereof listed after these terms, but do not preclude the other elements or objects. The phrases "connect", "connected", etc., are not intended to define a physical connection or mechanical connection, but may include an electrical connection, directly or indirectly. "On," "under," "right," "left" and the like are only used to indicate relative position relationship, and when the position of the described object is changed, the relative position relationship may be changed accordingly.

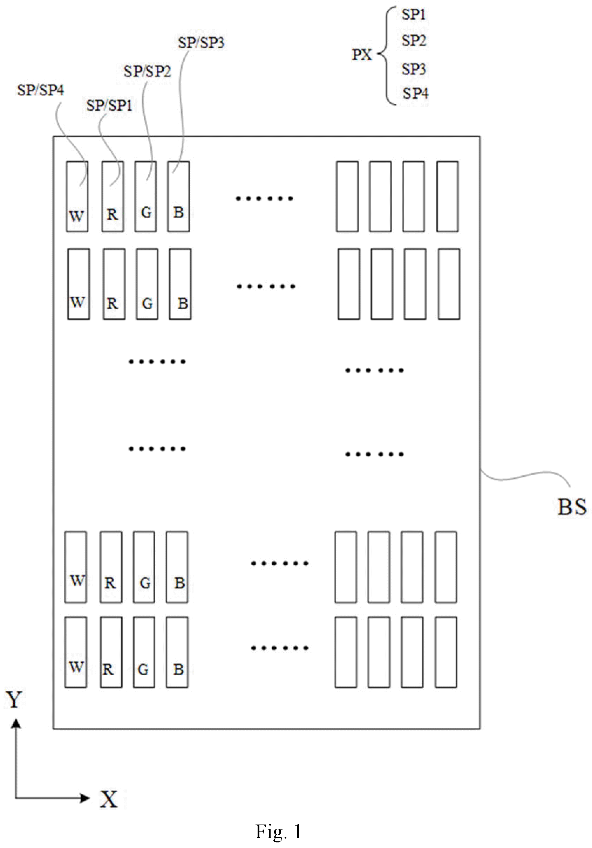

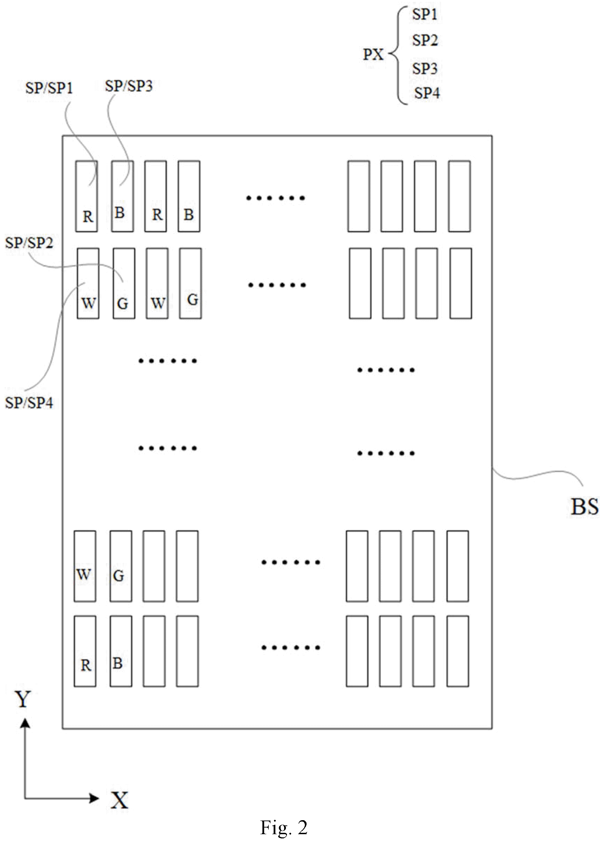

Fig. 1 is a schematic diagram of pixel arrangement in a strip form. Fig. 2 is a schematic diagram of pixel arrangement in a square form.

As shown in Fig. 1 and Fig. 2, the display panel includes a plurality of pixels PX, and each pixel PX of the plurality of pixels PX includes a plurality of sub-pixels SP.

As shown in Fig. 1, the pixel PX includes four sub-pixels SP, i.e., the pixel PX includes a sub-pixel SP1, a sub-pixel SP2, a sub-pixel SP3, and a sub-pixel SP4. As shown in Fig. 1, the sub-pixel SP4, the sub-pixel SP1, the sub-pixel SP2, and the sub-pixel SP3 are arranged in a direction X.

As shown in Fig. 2, the pixel PX includes four sub-pixels SP, i.e., the pixel PX includes a sub-pixel SP1, a sub-pixel SP2, a sub-pixel SP3, and a sub-pixel SP4.

As shown in Fig. 2, the sub-pixel SP1 and the sub-pixel SP4 are arranged in a direction Y, the sub-pixel SP3 and the sub-pixel SP2 are arranged in the direction Y, the sub-pixel SP1 and the sub-pixel SP3 are arranged in the direction X, and the sub-pixel SP4 and the sub-pixel SP2 are arranged in the direction X. That is, the four sub-pixels SP are arranged in two rows and two columns. For example, in the display panel shown in Fig. 2, in two adjacent columns of sub-pixels, several sub-pixels SP1 and several sub-pixels SP4 in one column of sub-pixels are arranged alternately in the direction Y, and several sub-pixels SP3 and several sub-pixels SP2 in the other column of sub-pixels are arranged alternately in the direction Y. For example, in the display panel shown in Fig. 2, in two adjacent rows of sub-pixels, several sub-pixels SP1 and several sub-pixels SP3 in one row of sub-pixels are arranged alternately in the direction X, and several sub-pixels SP4 and several sub-pixels SP2 in the other row of sub-pixels are arranged alternately in the direction X.

Fig. 1 and Fig. 2 are illustrated with reference to the case that the sub-pixel SP1 is a red sub-pixel, the sub-pixel SP2 is a green sub-pixel, the sub-pixel SP3 is a blue sub-pixel, and the sub-pixel SP4 is a white sub-pixel as an example. However, the light-emitting color of the sub-pixel SP is not limited to the above description, and other colors of light may be emitted. Embodiments of the present disclosure do not specifically limit the light-emitting colors of the sub-pixel SP1, the sub-pixel SP2, the sub-pixel SP3, and the sub-pixel SP4, and may be set according to needs.

Fig. 1 and Fig. 2 illustrate a base substrate BS. A plurality of pixels PX are located on the base substrate BS.

For a bottom-emission WOLED product, its pixel arrangement may be an arrangement in a strip form or an arrangement in a square form. In the bottom-emission strip-form pixel arrangement, there are many non-luminous areas among sub-pixels, so aperture ratio of the sub-pixels are generally lower, or the spacing between the sub-pixels is small on the premise of ensuring the design of the same aperture ratio, and the risk of light leakage is higher. The square-form pixel arrangement has the advantage of high aperture ratio and low risk of light leakage.

The display panel provided by the embodiments of the present disclosure may utilize the square-form pixel arrangement as shown in Fig. 2.

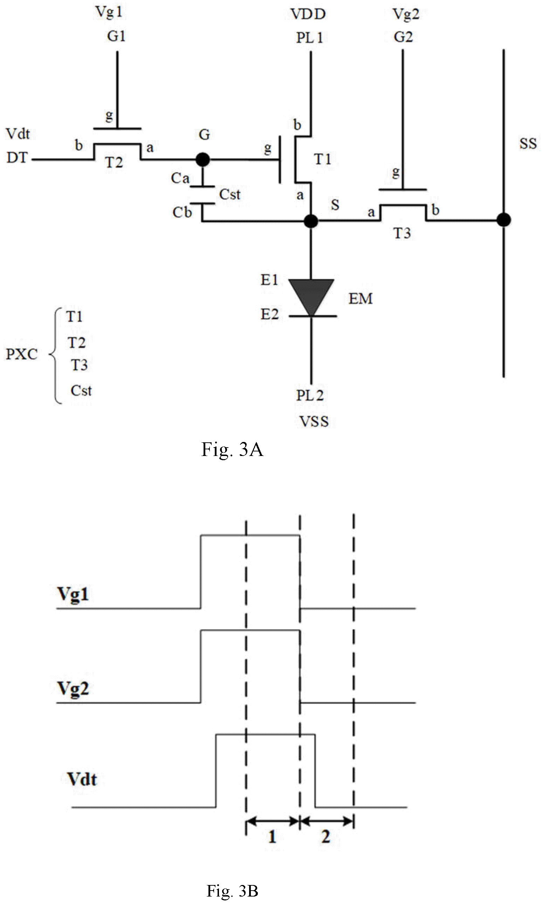

Fig. 3A is a schematic diagram of a 3T1C pixel circuit in a display panel provided by an embodiment of the present disclosure. A pixel circuit of the display panel provided by the embodiment of the present disclosure is not limited to the 3T1C pixel circuit. In this embodiment, the structure of the display panel is described by taking the pixel circuit of the display panel being the 3T1C circuit as an example. The pixel circuit may also be of other structures as needed. For example, the pixel circuit may further include a compensation circuit, a reset circuit, and the like, and this embodiment of the present disclosure is not limited thereto.

Referring to Fig. 3A, the pixel circuit includes a first transistor T1, a second transistor T2, a third transistor T3, and a storage capacitor Cst. The first transistor T1 is a drive transistor and the second transistor T2 is a data writing transistor. A first electrode of the second transistor T2 is electrically connected to a first electrode plate Ca of the storage capacitor Cst and a gate electrode of the first transistor T1. A second electrode of the second transistor T2 is connected to a data line DT and configured to receive a data signal Vdt. A gate electrode of the second transistor T2 is connected to a gate line G1, and the gate line G1 is configured to provide a first control signal Vg1. The second transistor T2 is configured to write the data signal Vdt to the gate electrode of the first transistor T1 and the storage capacitor Cst in response to the first control signal Vg1. A first electrode of the first transistor T1 is electrically connected to a second electrode plate Cb of the storage capacitor Cst and is configured to be electrically connected to a first electrode E1 of a light-emitting element EM. A second electrode of the first transistor T1 is connected to a first power line PL1 and is configured to receive a first power supply voltage (e.g., a high power supply voltage VDD). The first power line PL1 is configured to provide the first power supply voltage. The first transistor T1 is configured to control a current for driving the light-emitting element EM under the control of a voltage of the gate electrode of the first transistor T1. A first electrode of the third transistor T3 is electrically connected to the first electrode of the first transistor T1 and to a second electrode plate Cb of the storage capacitor Cst. A second electrode of the third transistor T3 is configured to be connected to a sense line SS to be further connected to an external detection circuit. A gate electrode of the third transistor T3 is connected to a gate line G2, and the gate line G2 is configured to provide a second control signal Vg2. The third transistor T3 is configured to detect electrical characteristics of a sub-pixel to which it belongs in response to the second control signal Vg2 to realize external compensation. The electrical characteristics include, for example, a threshold voltage and/or a carrier mobility of the first transistor T1, a threshold voltage, or a drive current of the light-emitting element EM. For example, the external detection circuit is, for example, a conventional circuit including a digital-to-analog converter (DAC) and an analog-to-digital converter (ADC), etc.. The embodiment of the present disclosure will not elaborate on this. Fig. 3A illustrates a gate electrode *g*, a first electrode *a*, and a second electrode *b* of a transistor.

As shown in Fig. 3A, the first electrode of the second transistor T2, the first electrode plate Ca of the storage capacitor Cst, and the gate electrode of the first transistor T1 are all connected to a node G.

As shown in Fig. 3A, the second electrode plate Cb, the first electrode of the first transistor T1, the first electrode of the third transistor T3, and the first electrode E1 of the light-emitting element are all connected to a node S.

As shown in Fig. 3A, a second electrode E2 of the light-emitting element EM is connected to a second power line PL2 to receive a second power supply voltage (e.g., a low power supply voltage VSS). The second power line PL2 is configured to supply the second power supply voltage.

For example, in a direction perpendicular to the base substrate BS, the second electrode plate Cb and the first electrode plate Ca are overlapped with each other, and an interlayer dielectric layer is disposed therebetween, thus forming the storage capacitor Cst.

The transistors used in the embodiments of the present disclosure may be thin-film transistors or field-effect transistors or other switching devices having the same characteristics. The embodiments of the present disclosure are all illustrated using thin film transistors as examples. Source electrode and drain electrode of the transistor adopted herein may be structurally symmetrical, so that the source electrode and the drain electrode may be structurally indistinguishable. In the embodiments of the present disclosure, in order to distinguish the two electrodes of each transistor other than the gate electrode, one of the electrodes is directly described as a first electrode and the other one as a second electrode. In addition, the transistors may be divided into N-type transistors and P-type transistors according to characteristics thereof. When the transistor is a P-type transistor, a turn-on voltage is a low-level voltage (e.g., 0V, -5V, -10V, or other suitable voltage) and a turn-off voltage is a high-level voltage (e.g., 5V, 10V, or other suitable voltage). When the transistor is an N-type transistor, the turn-on voltage is a high-level voltage (e.g., 5V, 10V, or other suitable voltage) and the turn-off voltage is a low-level voltage (e.g., 0V, -5V, -10V or other suitable voltage). It should be noted that the following description is illustrated by taking the transistors in Fig. 3A being N-type transistors as an example, however, which does not impose limitations to the present disclosure.

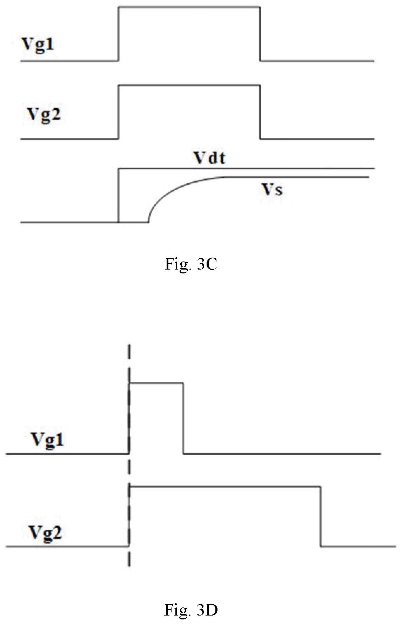

The operating principle of the pixel circuit shown in Fig. 3A is described below in conjunction with signal timing diagrams shown in Fig. 3B to Fig. 3D. Fig. 3B illustrates a signal timing diagram of the pixel circuit during a display process, and Fig. 3C and Fig. 3D illustrate signal timing diagrams of the pixel circuit during a detection process. It should be noted that the signal timing diagram of the pixel circuit shown in Fig. 3A is not limited to the cases shown in Fig. 3B to Fig. 3D.

For example, as shown in Fig. 3B, the display process of each frame of image includes a data writing and resetting stage 1 and a light emitting stage 2. Fig. 3B illustrates timing waveforms of respective signals in each stage. A working process of the 3T1C pixel circuit includes: in the data writing and resetting stage 1, the first control signal Vg1 and the second control signal Vg2 are both on signals, the second transistor T2 and the third transistor T3 are turned on, the data signal Vdt is transmitted to the gate electrode of the first transistor T1via the second transistor T2, an analog-to-digital converter writes a reset signal to the first electrode E1 of the light-emitting element EM (e.g., an anode of an OLED) via the sense line SS and the third transistor T3, and the first transistor T1 is turned on and generates a drive current to charge the first electrode E1 of the light-emitting element EM to a working voltage; in the light-emitting stage 2, the first control signal Vg1 and the second control signal Vg2 are both off signals, and due to a bootstrap effect of the storage capacitor Cst, the voltages at both ends of the storage capacitor Cst remain unchanged, and the first transistor T1 works in a saturated state and the current remains unchanged, while driving the light-emitting element EM to emit light.

For example, Fig. 3C illustrates a signal timing diagram of the pixel circuit during threshold voltage detection. A working process of the 3T1C pixel circuit includes: the first control signal Vg1 and the second control signal Vg2 are both on signals, the second transistor T2 and the third transistor T3 are turned on, and the data signal Vdt is transmitted to the gate electrode of the first transistor T1 via the second transistor T2; the analog-to-digital converter writes a reset signal to the first electrode E1 (the node S) of the light-emitting element EM via the sense line SS and the third transistor T3, the first transistor T1 is turned on to charge the node S until the first transistor T1 is turned off, and the digital-to-analog converter samples a voltage on the sense line SS to obtain a threshold voltage of the first transistor T1. The process may be carried out, for example, when the display apparatus is switched off. Vs in Fig. 3C indicates a voltage at the node S.

For example, Fig. 3D illustrates a signal timing diagram of the pixel circuit during carrier mobility detection. A working process of the 3T1C pixel circuit includes: in the first stage, the first control signal Vg1 and the second control signal Vg2 are both turned on, the second transistor T2 and the third transistor T3 are turned on, and the data signal Vdt is transmitted to the gate electrode of the first transistor T1 via the second transistor T2; the analog-to-digital converter writes a reset signal to the first electrode E1 (the node S) of the light-emitting element EM via the sense line SS and the third transistor T3; in the second stage, the first control signal Vg1 is an off signal, the second control signal Vg2 is an on signal, the second transistor T2 is turned off, and the third transistor T3 is turned on, so as to float the sense line SS; due to a bootstrap effect of the storage capacitor Cst, the voltages at both ends of the storage capacitor Cst remain unchanged, the first transistor T1 works in a saturated state and the current remains unchanged, while driving the light-emitting element to emit light, and then the digital-to-analog converter samples a voltage on the sense line SS, such that a carrier mobility in the first transistor T1 can be calculated by combining with the magnitude and duration of the light-emitting current. The process may be performed, for example, in a blanking phase between display phases.

By the detections above, the electrical characteristics of the first transistor T1 may be obtained and the corresponding compensation algorithm may be realized.

For example, the display panel may further include a data driving circuit and a scan driving circuit (not shown). The data driving circuit is configured to be able to send a data signal, such as the data signal Vdt according to a need (e.g., inputting an image signal of the display apparatus). The pixel circuit of each sub-pixel is also configured to receive the data signal and apply the data signal to the gate electrode of the first transistor. The scan driving circuit is configured to output various scanning signals, including, for example, the first control signal Vg1 and the second control signal Vg2 described above, which is, for example, an integrated circuit chip (IC) or a gate driver on an array (GOA) directly formed on the display panel.

For example, the display panel further includes a control circuit. For example, the control circuit is configured to control the data driving circuit to apply a data signal, and to control the gate driving circuit to apply a scanning signal. An example of the control circuit is a timing control circuit (T-con). The control circuit may be in various forms, for example, it may include a processor and a memory. The memory includes executable code, and the processor runs the executable code to perform the detection method described above.

For example, the processor may be a central processing unit (CPU), or other forms of processing apparatuses having data processing capabilities and/or instruction execution capabilities, which may include, for example, a microprocessor, and a programmable logic controller (PLC).

For example, the memory may include one or more computer program products, and the computer program products may include various forms of computer-readable storage media, such as a volatile memory and/or a non-volatile memory. The volatile memory may include, for example, a random access memory (RAM) and/or cache memory (cache), and the like. The non-volatile memory may include, for example, a read-only memory (ROM), a hard disk, a flash memory, and the like. One or more computer program instructions may be stored on the computer-readable storage medium, and the processor may run the computer program instructions to achieve desired functions. Various applications and various data, such as electrical characteristic parameters obtained in the detection method described above, may also be stored in the computer-readable storage medium.

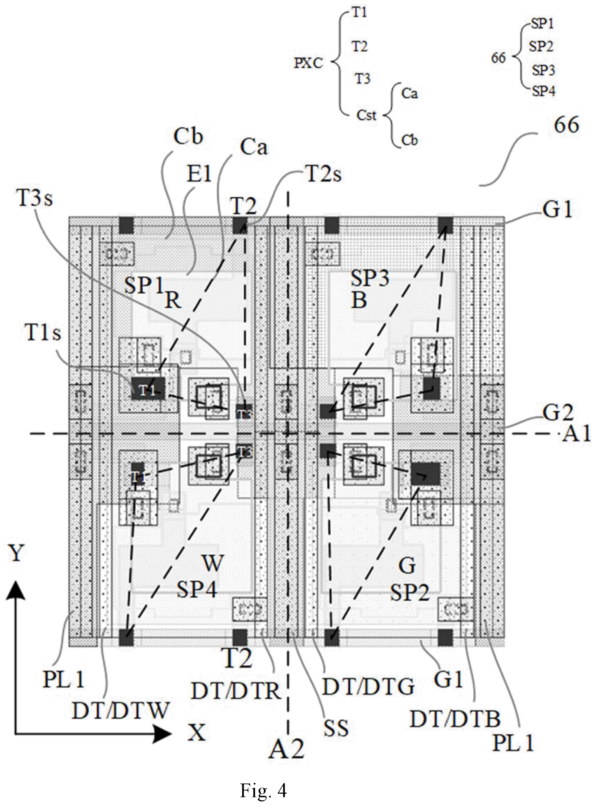

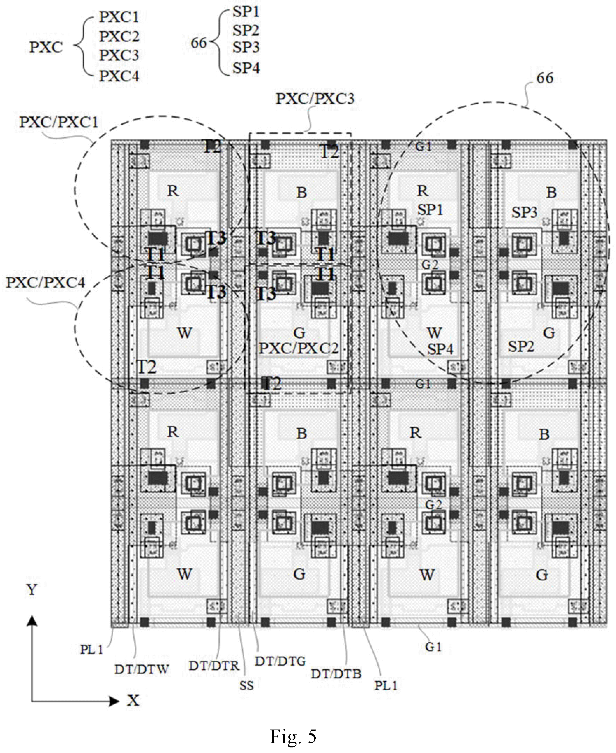

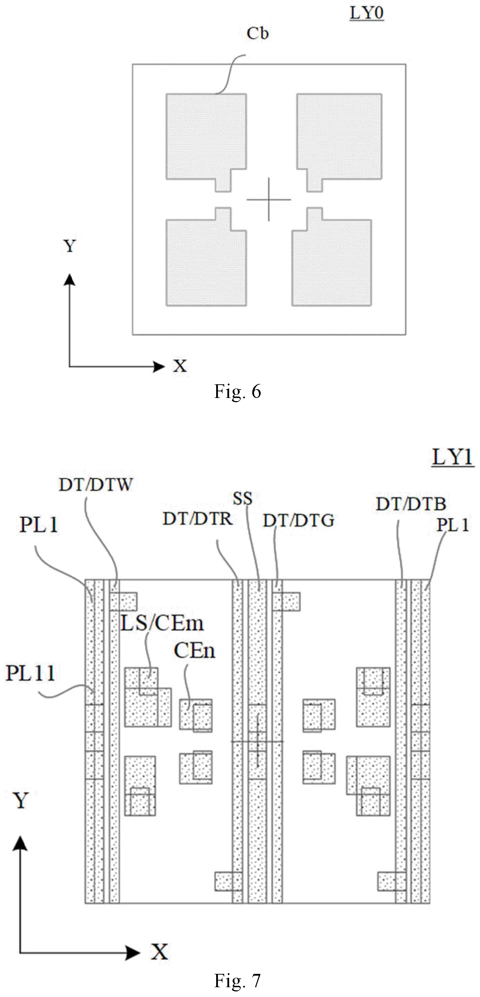

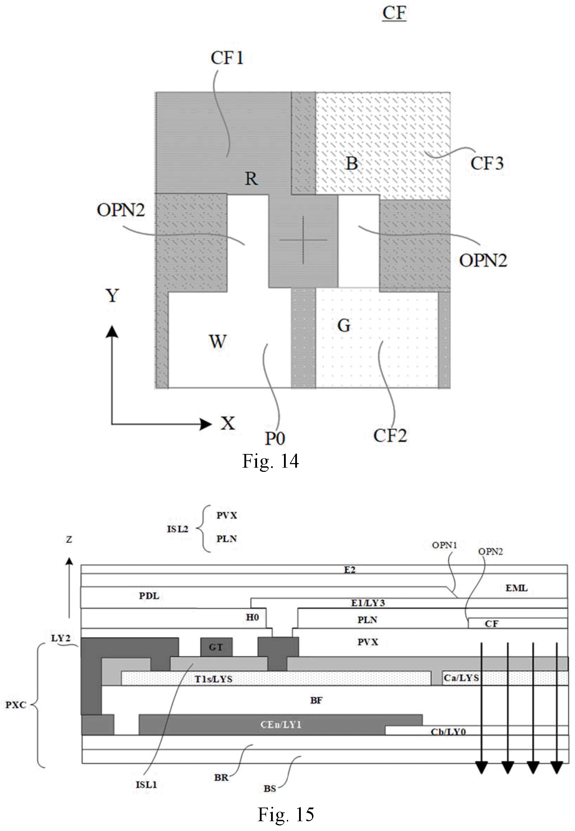

Fig. 4 is a layout diagram of a display panel provided by an embodiment of the present disclosure. Two rows and two columns of sub-pixels are illustrated in Fig. 4. Fig. 5 is a layout diagram of a display panel provided by an embodiment of the present disclosure. Four rows and four columns of sub-pixels are illustrated in Fig. 5. Fig. 6 to Fig. 14 are plan views of single layers of a display panel provided by an embodiment of the present disclosure. Fig. 15 is a cross-sectional view of a display panel provided by an embodiment of the present disclosure.

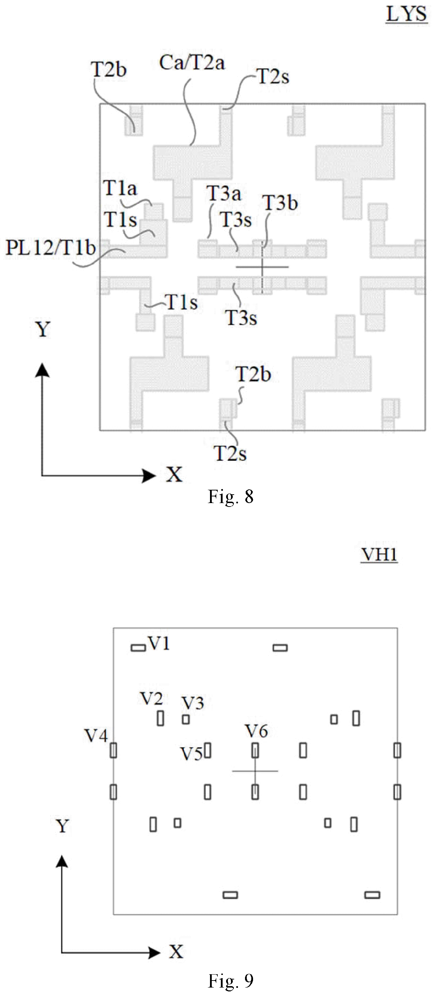

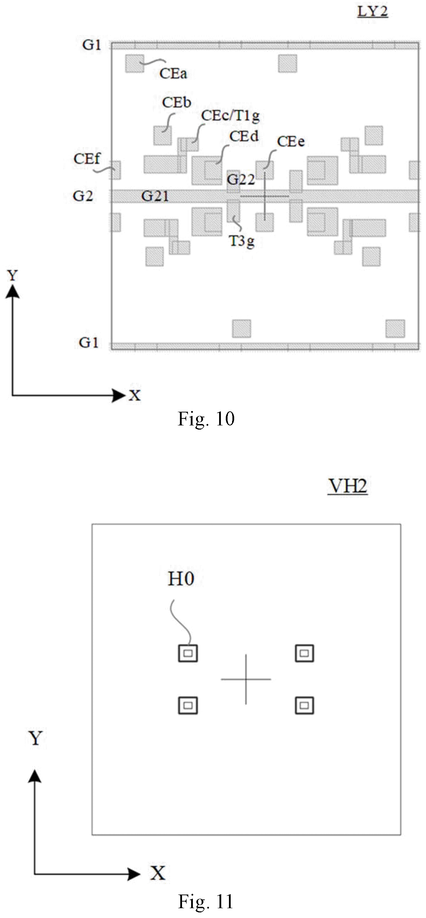

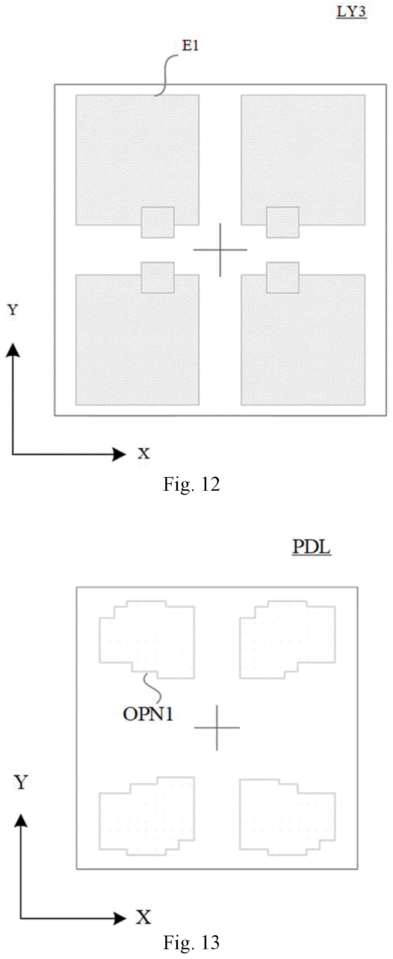

Fig. 6 is a plan view of a conductive layer LY0 in a display panel provided by an embodiment of the present disclosure. Fig. 7 is a plan view of a conductive layer LY1 in a display panel provided by an embodiment of the present disclosure. Fig. 8 is a plan view of a semiconductor-conductor layer LYS in a display panel provided by an embodiment of the present disclosure. Fig. 9 is a plan view of a first insulating layer (via holes VH1) in a display panel provided by an embodiment of the present disclosure. Fig. 10 is a plan view of a conductive layer LY2 in a display panel provided by an embodiment of the present disclosure. Fig. 11 is a plan view of a second insulating layer (via holes VH2) in a display panel provided by an embodiment of the present disclosure. Fig. 12 is a plan view of a conductive layer LY3 in a display panel provided by an embodiment of the present disclosure. Fig. 13 is a plan view of a pixel definition layer (pixel openings OPN1) in a display panel provided by an embodiment of the present disclosure. Fig. 14 is a plan view of a color filter layer CF in a display panel provided by an embodiment of the present disclosure.

As shown in Fig. 2 and Fig. 3A, and Fig. 4 to Fig. 14, an embodiment of the present disclosure provides a display panel including a plurality of sub-pixels SP, a gate line G1, and a gate line G2. At least one sub-pixel SP of the plurality of sub-pixels SP includes a pixel circuit PXC and a light-emitting element EM. The pixel circuit PXC includes a first transistor T1, a second transistor T2, and a third transistor T3. A first electrode of the second transistor T2 is connected to a gate electrode of the first transistor T1, and a first electrode of the third transistor T3 is connected to a first electrode of the first transistor T1. The gate line G1 is connected to a gate electrode of the second transistor T2, and the gate line G2 is connected to a gate electrode of the third transistor T3. The gate line G1 extends in a direction X, the gate line G2 extends in the direction X, the gate line G1 and the gate line G2 are spaced apart from each other in a direction Y, and the direction X intersects the direction Y.

In the display panel provided by the embodiment of the present disclosure, the gate line G1 extends in the direction X, the gate line G2 extends in the direction X, the gate line G1 and the gate line G2 are spaced apart from each other in a direction Y, and the second transistor T2 and the third transistor T3 are connected to different gate lines respectively, so as to separately input signals to facilitate separate control of the second transistor T2 and the third transistor T3. The position adjustment of the transistors facilitates the structural arrangement of the pixel circuits and the layout design to help to increase the aperture ratio and improve the display effect.

For example, as shown in Fig. 4, Fig. 5, and Fig. 10, the gate line G1 and the gate line G2 connected to the second transistor T2 and the third transistor T3 of the same sub-pixel SP respectively are different gate lines, thus facilitating the layout design and the separate control of the second transistor T2 and the third transistor T3. Taking a sub-pixel in the upper left corner shown in Fig. 4 and Fig. 5 as an example, the second transistor T2 and the third transistor T3 are spaced apart in the direction Y, the gate line G1 and the gate line G2 are spaced apart in the direction Y, and the gate line G1 and the gate line G2 are two different gate lines.

For example, as shown in Fig. 4, Fig. 5, and Fig. 10, a plurality of gate lines G1 are provided, a plurality of gate lines G2 are provided, and the plurality of gate lines G1 and the plurality of gate lines G2 are arranged alternately in the direction Y to facilitate a periodic arrangement of sub-pixels.

Fig. 4 illustrates three transistors in the same sub-pixel SP. The three transistors in the same sub-pixel SP are connected with dotted lines to form a triangle.

Fig. 4 and Fig. 8 illustrate active layers of the transistors. Fig. 4 and Fig. 8 illustrate an active layer T1s of the first transistor T1, an active layer T2s of the second transistor T2, and an active layer T3s of the third transistor T3.

For example, as shown in Fig. 4 and Fig. 5, the third transistor T3 is closer to the first transistor T1 than the second transistor T2 in the same sub-pixel SP to facilitate the layout design. As shown in Fig. 4 and Fig. 5, a distance between the third transistor T3 and the first transistor T1 is smaller than a distance between the second transistor T2 and the first transistor T1. A comparison of distances between the transistors may be referred to a comparison of distances between the active layers of the transistors.

For example, as shown in Fig. 4 and Fig. 5, the plurality of sub-pixels SP include a plurality of pixel groups 66. Each pixel group 66 of the plurality of pixel groups 66 includes two rows and two columns of a total of four sub-pixels SP, the same gate line G1 is connected to each of the two second transistors T2 in the two rows of sub-pixels SP, and pixel circuits at positions of the four sub-pixels SP in the same pixel group 66 are in symmetrical arrangement to facilitate the layout design. Fig. 4 illustrates one pixel group 66. Fig. 5 illustrates four pixel groups 66. As shown in Fig. 4 and Fig. 5, the same gate line G1 is connected to each of two second transistors T2 in the two rows of sub-pixels SP. One of the second transistors T2 (the second transistor T2 on the left) is used for transmitting a data signal to a sub-pixel located above the gate line G1, and the other second transistor T2 (the second transistor T2 on the right) is used for transmitting a data signal to a sub-pixel located below the gate line G1. Therefore, with respect to the layout design, the pixel circuits at the positions of the four sub-pixels SP in the same pixel group 66 are in symmetrical arrangement. For example, the pixel circuits at the positions of the four sub-pixels SP in the same pixel group 66 being in symmetrical arrangement in layout may refer to that the positions of the transistors are symmetrical in layout. The layout design on the position of the same pixel group 66 not only includes the transistors belonging to the four sub-pixels SP in this pixel group 66, but also includes the second transistors T2 connected to the gate line G1 in the area where the pixel group is located, for example, the four second transistors T2 that are not connected by the dotted lines in Fig. 4. That is, taking Fig. 4 as an example, the transistors illustrated in Fig. 4 all fall within the layout of the pixel circuits at the positions of the four sub-pixels SP in the same pixel group 66.

For example, as shown in Fig. 4 and Fig. 5, two second transistors T2 in the two rows of sub-pixels SP connected to the same gate line G1 are arranged in the direction X. For example, the two second transistors T2 in the two rows of sub-pixels SP connected to the same gate line G1 are arranged sequentially in the direction X. That is, the two second transistors T2 in the upper and lower rows of sub-pixels share the same gate line G1 to save space and facilitate the layout.

For example, as shown in Fig. 4 and Fig. 5, the four sub-pixels SP in the same pixel group 66 include a first sub-pixel SP1, a second sub-pixel SP2, a third sub-pixel SP3, and a fourth sub-pixel SP4. The first sub-pixel SP1 and the third sub-pixel SP3 are arranged in the direction X, the fourth sub-pixel SP4 and the second sub-pixel SP2 are arranged in the direction X, the first sub-pixel SP1 and the fourth sub-pixel SP4 are arranged in the direction Y, and the third sub-pixel SP3 and the second sub-pixel SP2 are arranged in the direction Y.

For example, as shown in Fig. 4 and Fig. 5, in the same sub-pixel SP, a center connecting line of active layers of the first transistor T1, the second transistor T2 and the third transistor T3 in each of two sub-pixels of four sub-pixels in the same pixel group 66 forms an obtuse triangle. Fig. 5 does not illustrate the triangle formed with the center connecting line of the active layers of the transistors, and reference may be made to Fig. 4. As shown in Fig. 4, the center connecting line of the active layers of the first transistor T1, the second transistor T2, and the third transistor T3 of the fourth sub-pixel SP4 forms an obtuse triangle. As shown in Fig. 4, the center connecting line of the active layers of the first transistor T1, the second transistor T2, and the third transistor T3 of the third sub-pixel SP3 forms an obtuse triangle. The fourth sub-pixel SP4 and the third sub-pixel SP3 having the active layers of which the center connecting lines form obtuse triangles are located in different rows and in different columns.

For example, as shown in Fig. 4 and Fig. 5, the center connecting line of the active layers of the first transistor T1, the second transistor T2, and the third transistor T3 of each of the other two sub-pixels of the four sub-pixels in the same pixel group 66 of the same sub-pixel SP forms an acute triangle. Fig. 5 does not illustrate the triangle formed with the center connecting line of the active layers of the transistors, and reference may be made to Fig. 4. As shown in Fig. 4, the center connecting line of the active layers of the first transistor T1, the second transistor T2, and the third transistor T3 of the first sub-pixel SP1 forms an acute triangle. As shown in Fig. 4, the center connecting line of the active layers of the first transistor T1, the second transistor T2, and the third transistor T3 of the second sub-pixel SP2 forms an acute triangle. The first sub-pixel SP1 and the second sub-pixel SP2 having the active layers of which the center connecting lines form acute triangles are located in different rows and in different columns.

Fig. 5 illustrates a pixel circuit PXC1 of the first sub-pixel SP1, a pixel circuit PXC2 of the second sub-pixel SP2, a pixel circuit PXC3 of the third sub-pixel SP3, and a pixel circuit PXC4 of the fourth sub-pixel SP4.

For example, as shown in Fig. 4 and Fig. 5, the pixel circuits PXC at the positions of the four sub-pixels SP in the same pixel group 66 are in symmetrical arrangement relative to a first axis A1 parallel with the direction X, and are in symmetrical arrangement relative to a second axis A2 parallel with the direction Y. Fig. 4 illustrates the first axis A1 and the second axis A2. For example, the first axis line A1 is perpendicular to the second axis line A2. Similar to the above, the symmetrical arrangement of the pixel circuits PXC at the positions of the four sub-pixels SP in the same pixel group 66 not only includes the transistors belonging to the four sub-pixels SP in this pixel group 66, but also includes the second transistors T2 connected to the gate line G1 in an area where the pixel group is located, for example, the four second transistors T2 that are not connected by the dotted lines in Fig. 4. That is, taking Fig. 4 as an example, the transistors illustrated in Fig. 4 all fall within the layout of the pixel circuits at the positions of the four sub-pixels SP in the same pixel group 66.

For example, as shown in Fig. 4 and Fig. 5, the first sub-pixel SP1 is a red sub-pixel, the second sub-pixel SP2 is a green sub-pixel, the third sub-pixel SP3 is a blue sub-pixel, and the fourth sub-pixel SP4 is a white sub-pixel. Of course, light emitting conditions of the respective sub-pixels are not limited to this, and may also be adjusted to emit other colors of light according to needs

Fig. 6 illustrates a conductive layer LY0. The conductive layer LY0 may be made of a transparent conductive material. For example, the conductive layer LY0 may be made of indium tin oxide. Fig. 6 illustrates four second electrode plates Cb. The four second electrode plates Cb are spaced apart from each other.

Fig. 7 illustrates a conductive layer LY1. As shown in Fig. 7, the conductive layer LY1 includes a first power line PL1, a data line DT, a connection portion CEm, a connection portion CEn, and a sense line SS. Fig. 7 illustrates two first power lines PL1. Fig. 7 illustrates four data lines DT. The four data lines DT include a first data line DTR, a second data line DTG, a third data line DTB, and a fourth data line DTW. As shown in Fig. 15, no insulating layer is provided between the conductive layer LY0 and the conductive layer LY1. As shown in Fig. 7 and Fig. 15, the connection portion CEn and the second electrode plate Cb are in direct contact with and connected to each other. The connection portion CEm is in direct contact with and connected to the second electrode plate Cb. The connection portion CEm serves as a light shield layer LS of the active layer T1s (channel) of the first transistor T1.

Fig. 8 illustrates a semiconductor-conductor layer LYS. As shown in Fig. 8, the semiconductor-conductor layer LYS includes active layers (channels) of transistors of a semiconductor material and conductive elements (a first electrode plate Ca, a power connection line PL12, and source electrodes and drain electrodes of respective transistors). Fig. 8 illustrates an active layer T1s of a first transistor T1, an active layer T2s of a second transistor T2, and an active layer T3s of a third transistor T3. The source electrode and drain electrode of each transistor are on two sides of this active layer of the transistor, respectively. The power connection line PL12 and the active layer T1s are connected and are of an integral structure. The conductive elements are each a conductor formed by doping on semiconductor. The power connection line PL12 and a second electrode of the first transistor T1 are of an integral structure. Fig. 8 shows a portion of a display panel. In the whole display panel, the active layer T2s, a first electrode T2a of the second transistor T2, and a second electrode T2b of the second transistor T2 are of an integral structure. For example, if the structure shown in Fig. 8 is copied and translated downward and connected to the structure shown in Fig. 8, the active layer T2s, the first electrode T2a of the second transistor T2, and the second electrode T2b of the second transistor T2 can be seen as an integral structure, as shown in Fig. 5.

Fig. 9 illustrates a plan view of a first insulating layer (via holes VH1) in the display panel. Fig. 9 illustrates this first insulating layer through the via holes therein. As shown in Fig. 9, the via holes VH1 in the first insulating layer include a via hole V1, a via hole V2, a via hole V3, a via hole V4, a via hole V5, and a via hole V6.

For example, the first insulating layer may be a first insulating layer ISL1 in a display panel shown in Fig. 15. For example, the first insulating layer ISL1 may be a gate insulating layer, but is not limited thereto.

Fig. 10 illustrates a conductive layer LY2. As shown in Fig. 10, the conductive layer LY2 includes a connection portion CEa, a connection portion CEb, a connection portion CEc, a connection portion CEd, a connection portion CEe, a connection portion CEf, a gate line G1, and a gate line G2. Fig. 10 illustrates two gate lines G1 and a gate line G2 between the two gate lines G1. Fig. 10 illustrates a gate electrode T3g of a third transistor T3. The gate electrode T3g protrudes from the gate line G2. The gate electrode T3g of the third transistor T3 and the gate line G2 are of an integral structure.

Fig. 11 illustrates a plan view of a second insulating layer (via holes VH2) in the display panel. Fig. 11 illustrates this second insulating layer through the via holes therein. As shown in Fig. 11, the via holes VH2 in the second insulating layer include via holes H0. Fig. 11 illustrates four via holes H0.

For example, the second insulating layer may be a second insulating layer ISL2 in the display panel shown in Fig. 15. For example, the second insulating layer ISL2 may include a passivation layer PVX and a planarization layer PLN.

Fig. 12 illustrates a conductive layer LY3. As shown in Fig. 12, the conductive layer LY3 includes a first electrode E1 of the light-emitting element. Fig. 12 illustrates four first electrodes E1.

Fig. 13 illustrates a plan view of a pixel definition layer (pixel openings OPN1) in the display panel. Fig. 13 illustrates the pixel definition layer PDL through the pixel openings OPN1 therein. The pixel opening OPN1 is configured to expose at least a portion of the first electrode E1. The pixel openings OPN1 of the pixel definition layer PDL are configured to define light emitting areas of the sub-pixels, i.e., actual light emitting areas of the sub-pixels. Fig. 13 illustrates four pixel openings OPN1. The area outside the four pixel openings OPN1 in Fig. 13 is the body of the pixel definition layer PDL.

Fig. 14 illustrates a plan view of a color filter layer CF in the display panel. As shown in Fig. 14, the color filter layer CF includes a first filter portion CF1, a second filter portion CF2, and a third filter portion CF3. The first filter portion CF1 is configured to transmit light of a first color, the second filter portion CF2 is configured to transmit light of a second color, and the third filter portion CF3 is configured to transmit light of a third color. Fig. 14 is illustrated by taking the case that the light of a first color is a red light, the light of a second color is a green light, and the light of a third color is a blue light as an example. A light transmitting portion P0 may be provided at a white sub-pixel. For example, the light transmitting portion P0 may be a transparent resin layer, but is not limited thereto.

As shown in Fig. 6 to Fig. 10, the connection portion CEe is connected to a second electrode T3b of the third transistor T3 on one side of the active layer T3s and to the sense line SS through the via hole V6 respectively. The conductor part on one side of the active layer T3s and connected to the connection portion CEe may serve as the second electrode T3b of the third transistor T3.

As shown in Fig. 6 to Fig. 10, the connection portion CEd is connected to a first electrode T3a of the third transistor T3 on one side of the active layer T3s and to the connection portion CEn through the via hole V5 respectively, so that the first electrode T3a of the third transistor T3 is connected to the second electrode plate Cb through the connection portion CEn and the connection portion CEd. The conductor part on one side of the active layer T3s and connected to the connection portion CEd may serve as the first electrode T3a of the third transistor T3.

As shown in Fig. 6 to Fig. 10, the connection portion CEc (the gate electrode of the first transistor T1) is connected to the first electrode plate Ca through the via hole V3. The conductor part on one side of the active layer T2s and connected to the connection portion CEc may serve as the first electrode T2a of the second transistor T2.

As shown in Fig. 9 to Fig. 12, the first electrode E1 is connected to the connection portion CEd through the via hole H0, and then is connected to the connection portion CEn, to be further connected to the second electrode plate Cb.

As shown in Fig. 6 to Fig. 10, the connection portion CEb is connected to the connection portion CEm and the first electrode T1a of the first transistor T1 on one side of the active layer T1s through the via hole V2, respectively. Because the connection portion CEm is connected to the second electrode plate Cb, the first electrode T1a of the first transistor T1 is connected to the second electrode plate Cb. The conductor part on one side of the active layer T1s and connected to the connection portion CEb may serve as the first electrode T1a of the first transistor T1.

As shown in Fig. 6 to Fig. 10, the connection portion CEa is respectively connected to the data line DT and the second electrode T2b of the second transistor T2 on one side of the active layer T2s through the via hole V1 such that the data line DT is connected to the second electrode T2b of the second transistor T2. The conductor part on one side of the active layer T2s and connected to the data line DT may serve as the second electrode T2b of the second transistor T2.

As shown in Fig. 6 to Fig. 10, the connection portion CEf is connected to the first power line PL1 (power connection line PL12) and the second electrode T1b of the first transistor T1 on one side of the active layer T1s through the via hole V4 respectively, so that the first power line PL1 is connected to the second electrode T1b of the first transistor T1.

Crosses shown in Fig. 6 to Fig. 14 indicate centers of the diagrams respectively. Fig. 6 to Fig. 14 may be plan views of single layers of the display panel shown in Fig. 4. Fig. 4 may be a pixel group in the display panel shown in Fig. 5.

As shown in Fig. 3A, Fig. 6 to Fig. 15, a barrier layer BR is disposed on the base substrate BS, the conductive layer LY0 and the conductive layer LY1 are located on the barrier layer BR, the conductive layer LY0 is formed prior to the conductive layer LY1, a buffer layer BF is disposed on the conductive layer LY0 and the conductive layer LY1, the semiconductor-conductor layer LYS is disposed on the buffer layer BF, the first insulating layer ISL1 is disposed on the semiconductor-conductor layer LYS , the conductive layer LY2 is disposed on the first insulating layer ISL1, the passivation layer PVX is disposed on the conductive layer LY2, the color filter layer CF is disposed on the passivation layer PVX, the planarization layer PLN is disposed on the color filter layer CF, the passivation layer PVX and the planarization layer PLN form the second insulating layer ISL2, the first electrode E1 of the light-emitting element ( in the conductive layer LY3) is connected to the pixel circuit PXC through the via hole H0 running through the second insulating layer ILS2. As shown in Fig. 15, a pixel definition layer PDL is disposed on the first electrode E1. A light-emitting functional layer EML is disposed on the pixel definition layer PDL, and a second electrode E2 is disposed on the light-emitting functional layer EML. Fig. 15 illustrates a pixel opening OPN1 of the pixel definition layer PDL. Fig. 15 further illustrates an opening OPN2 of the color filter layer CF. The color filter layer in the display panel shown in Fig. 15 may be a filter portion (e.g., the first filter portion CF1, the second filter portion CF2, or the third filter portion CF3) or the light transmitting portion P0. The color filter layer CF shown in Fig. 15 may not be provided with any filter portion and light transmitting portion P0 at a white sub-pixel.

In an embodiment of the present disclosure, the first electrode E1, the light-emitting functional layer EML, and the second electrode E2 form the light-emitting element EM. For example, the light-emitting element EM includes, but is not limited to, an organic light emitting diode (OLED).

In an embodiment of the present disclosure, the base substrate BS may be a rigid substrate or a flexible substrate. For example, the rigid substrate includes, but is not limited to, a glass substrate, and the flexible substrate includes, but is not limited to, a polyimide substrate.

In an embodiment of the present disclosure, any one of the barrier layer BR, the buffer layer BF, the first insulating layer ISL1, and the passivation layer PVX may be an inorganic insulating material layer. For example, the inorganic insulating material layer includes at least one of silicon oxide, silicon nitride, or silicon nitride oxide, but is not limited thereto.

For example, in an embodiment of the present disclosure, any one of the planarization layer PLN and the pixel definition layer PDL may be an organic insulating material layer. For example, the organic insulating material layer includes resin, but is not limited thereto.

For example, in an embodiment of the present disclosure, the conductive layer LY0, the conductive layer LY1, the conductive layer LY2, and the conductive layer LY3 are all made of a conductive material.

For example, the conductive layer LY0 and the conductive layer LY3 may both be made of a transparent conductive oxide such as indium tin oxide.

For example, the conductive layer LY1 and the conductive layer LY2 may both be made of a metal.

For example, in an embodiment of the present disclosure, the second electrode E2 may be a reflective electrode to help to improve the display effect.

For example, in an embodiment of the present disclosure, the first electrode E1 may be an anode and the second electrode E2 may be a cathode.

For example, the first electrode E1 is made of a conductive material. For example, the material of the first electrode E1 includes a metal and a conductive metal oxide. For example, the first electrode E1 is of a structure in which indium tin oxide (ITO), silver (Ag), and indium tin oxide (ITO) are stacked. The material and structure of the first electrode E1 may be set according to needs.

For example, the second electrode E2 is made of a conductive material. For example, the material of the second electrode E2 includes a metal or an alloy. For example, the material of the second electrode E2 includes a Mg/Ag alloy. The material and structure of the second electrode E2 may be set according to needs.

It should be noted that layer structures of cross-sectional views of the display panel provided by the embodiments of the present disclosure are not limited to that shown in Fig. 15, and a person skilled in the art may make adjustments on the basis thereof to obtain other layer structures.

For example, as shown in Fig. 3A and Fig. 4 to Fig. 15, the display panel further includes a data line DT, a first power line PL1, and a sense line SS. The data line DT is connected to a second electrode of the second transistor T2, the first power line PL1 is connected to a second electrode of the first transistor T1, the sense line SS is connected to a second electrode of the third transistor T3, and the data line DT, the first power line PL1, and the sense line SS all extend in the direction Y.

For example, as shown in Fig. 4, Fig. 5, and Fig. 7, a plurality of data lines DT are provided , the plurality of data lines DT includes a first data line DTR, a second data line DTG, a third data line DTB, and a fourth data line DTW; the first data line DTR is connected to a second transistor T2 of the first sub-pixel SP1, the second data line DTG is connected to a second transistor T2 of the second sub-pixel SP2, the third data line DTB is connected to a second transistor T2 of the third sub-pixel T3, and the fourth data line DTW is connected to a second transistor T2 of the fourth sub-pixel SP4.

For example, as shown in Fig. 4, Fig. 5, Fig. 7, and Fig. 13, the fourth data line DTW, the first data line DTR, the second data line DTG, and the third data line DTB are arranged in the direction X; the sense line SS is disposed between the first data line DTR and the second data line DTG; and the first data line DTR, the sense line SS, and the second data line DTG are located between pixel openings OPN1 of two adjacent columns of sub-pixels SP.

In the display panel provided by the embodiment of the present disclosure, two data lines are arranged on two sides of the sense line SS respectively by adjusting positions of the data lines, which is conducive to wiring and increasing the aperture ratio of the sub-pixels.

In the display panel shown in Fig. 4 and Fig. 5, two or three signal lines are disposed between pixel openings OPN1 of two adjacent columns of sub-pixels SP, which is conducive to wiring and increasing the aperture ratio of the sub-pixels.

For example, as shown in Fig. 4, Fig. 5, and Fig. 13, the fourth data line DTW and the third data line DTB are adjacent to two first power lines PL1, the fourth data line DTW and the first power line PL1 adjacent thereto are located between pixel openings OPN1 of two adjacent columns of sub-pixels SP, and the third data line DTB and the first power line PL1 adjacent thereto are located between pixel openings OPN1 of two adjacent columns of sub-pixels SP, thus forming a structure in which a first power line PL1, a fourth data line DT, a column of pixel openings OPN1, a first data line DT, a sense line SS, a second data line DT, a column of pixel openings OPN1, a third data line DTB, and the other first power line PL1 are sequentially arranged in the direction X. According to the display panel, by balancing the distance distribution of opaque signal lines between sub-pixels, the aperture ratio is increased while the risk of light leakage between the sub-pixels is reduced.

For example, as shown in Fig. 4, Fig. 5, Fig. 7 and Fig. 13, the plurality of data lines DT are not overlapped with one another.

In the display panel provided by the embodiments of the present disclosure, the data lines DT are not overlapped with one another, thus reducing coupling, avoiding mutual interference of signals, avoiding affecting the display, and improving the display effect.

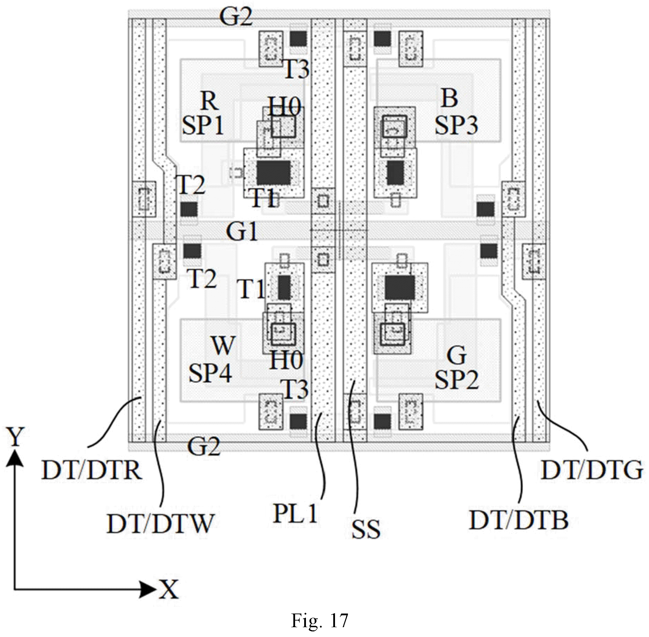

For example, as shown in Fig. 17, a first power line PL1 and a sense line SS are located between pixel openings OPN1 of two adjacent columns of sub-pixels SP, a first data line DTR and a fourth data line DTW are located between pixel openings OPN1 of two adjacent columns of sub-pixels SP, and a third data line DTB and a second data line DTG are located between pixel openings OPN1 of two adjacent columns of sub-pixels SP, thus forming a structure in which the first data line DTR, the fourth data line DTW, a column of pixel openings OPN1, the first power line PL1, the sense line SS, another column of pixel openings OPN1, the third data line DTB, and the second data line DTG are sequentially arranged in a direction X. According to the display panel, by balancing the distance distribution of light-tight signal lines between sub-pixels, the aperture ratio is increased while the risk of light leakage between the sub-pixels is reduced.

In the display panel provided by the embodiments of the present disclosure, the signal lines are uniformly distributed, which is conducive to wiring and layout.

For example, as shown in Fig. 17, two signal lines extending in a direction Y are arranged between pixel openings OPN1 of two adjacent columns of sub-pixels SP to facilitate wiring of vertical signal lines, facilitate the increase of the aperture ratio, and improve the display effect.

In the display panel provided by the embodiments of the present disclosure, signal lines are uniformly distributed among different sub-pixels, which can increase the pixel openings and reduce light leakage. Besides, the data lines DT and the sense line SS are not overlapped, avoiding affecting the data signals and improving the display effect.

The signal lines in the embodiments of the present disclosure include conductive lines extending in the direction Y such as the data line DT, the first power line PL1, and the sense line SS.

For example, as shown in Fig. 4, Fig. 5, and Fig. 7, the display panel further includes a light shield layer LS. The light shield layer LS is overlapped with the first transistor T1 to improve performance of the first transistor T1. For example, the light shield layer LS is overlapped with the active layer T1s of the first transistor T1.

For example, as shown in Fig. 4 to Fig. 15, the pixel circuit PXC further includes a storage capacitor Cst. The storage capacitor Cst includes a first electrode plate Ca and a second electrode plate Cb. The first electrode plate Ca is connected to the gate electrode of the first transistor T1, the second electrode plate Cb is connected to the first electrode of the first transistor T1, the first electrode of the third transistor T3, and the first electrode of the light-emitting element EM, respectively. The second electrode plate Cb is connected to the light shield layer LS.

For example, as shown in Fig. 14 and Fig. 15, the display panel further includes a color filter layer CF. The color filter layer CF is located between the light-emitting element EM and the pixel circuit PXC, the color filter layer CF includes an opening OPN2, and the light-emitting element EM passes through the opening OPN2 of the color filter layer CF to be connected to the pixel circuit PXC. In this way, a bottom-emission display panel is formed.

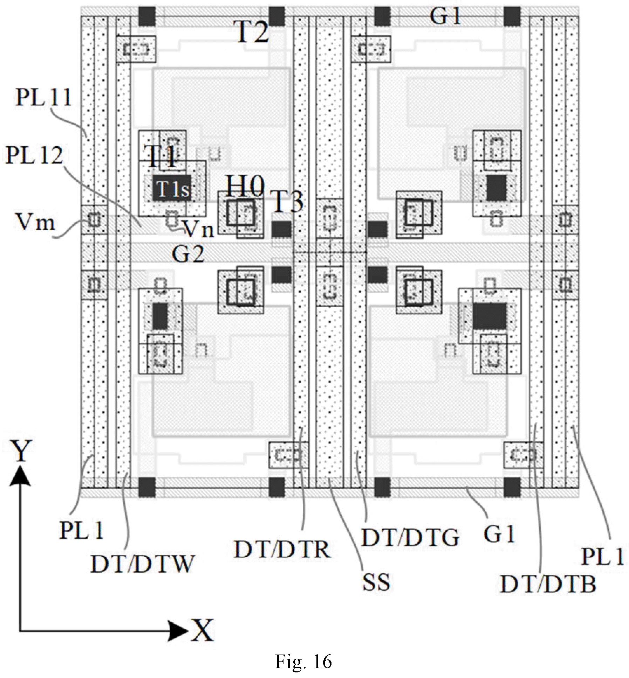

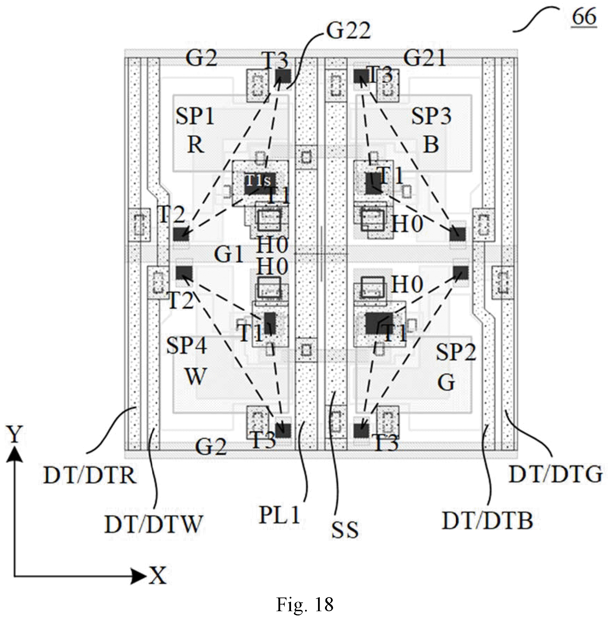

Fig. 16 is a layout diagram of a display panel provided by another embodiment of the present disclosure. Fig. 17 is a layout diagram of a display panel provided by another embodiment of the present disclosure. Fig. 18 is a layout diagram of a display panel provided by another embodiment of the present disclosure.

For example, as shown in Fig. 7, Fig. 8 and Fig. 16, the first power line PL1 includes a power body line PL11 and a power connection line PL12. The power body line PL11 extends in the direction Y. The power connection line PL12 extends in the direction X. The power connection line PL12, the gate line G1, and the gate line G2 are located in the same layer. In the display panel shown in Fig. 16, the power connection line PL12 is adjusted to the conductive layer LY2 and is made of a conductive material with good current resistance, which is conducive to improving the uniformity of the power connection line PL12 and improving the conductive effect, accordingly.

As shown in Fig. 8, the power connection line PL12 adopts a conductor obtained by doping on a semiconductor.

For example, as shown in Fig. 16, the power connection line PL12 is located between the gate line G2 and the active layer T1s of the first transistor T1.

For example, as shown in Fig. 16, the power connection line PL12 is connected to the power body line PL11 through a via hole Vm, and the power connection line PL12 is connected to the first transistor T1 through a via hole Vn.

For example, as shown in Fig. 15, the light-emitting element EM is connected to the pixel circuit PXC through a via hole H0. As shown in Fig. 18, the via hole H0 is closer to the gate line G1 than the active layer T1s of the first transistor T1 in the same sub-pixel SP. Because the via hole H0 is deep, the via hole H0 is farther away from the pixel opening OPN1, and the influence of the deep via hole H0 on the display can be avoided, thus reducing the risk of light leakage of the sub-pixels and improving the display effect.

As shown in Fig. 18, in the same sub-pixel SP, the via hole H0 and the active layer T1s of the first transistor T1 are sequentially arranged in the direction Y.

For example, as shown in Fig. 10 and Fig. 18, the gate line G2 includes a gate body line G21 and a branch G22, the gate body line G21 extends in the direction X, the branch G22 extends in the direction Y, the gate body line G21 and the branch G22 are of an integral structure, and the branch G22 serves as the gate electrode T3g of the third transistor T3.

For example, as shown in Fig. 18, in the same sub-pixel SP, a center connecting line of active layers of the first transistor T1, the second transistor T2 and the third transistor T3 in each sub-pixel of four sub-pixels in the same pixel group 66 forms an obtuse triangle.

As shown in Fig. 18, the via hole H0 is outside the obtuse triangle.

In the display panel shown in Fig. 4 to Fig. 17, at least a portion of the via hole H0 is within the triangle (obtuse triangle or acute triangle) formed by the center connecting line of the active layers of the transistors.

As shown in Fig. 18, second transistors T2 of two adjacent rows of sub-pixels are arranged in the direction Y.

For example, as shown in Fig. 4 to Fig. 18, the power connection line PL12 of each sub-pixel is individually connected to the power body line PL11, and accordingly, the sub-pixel difference caused by one being connected to multiple can be reduced.

An embodiment of the present disclosure further provides a display apparatus including any of the display panels described above. For example, the display apparatus is a bottom-emission display apparatus. The beneficial effects of the display apparatus can be referred to the beneficial effects of the display panel and will not be repeated herein.

In some figures of the embodiments of the present disclosure, plan views illustrate the direction X and the direction Y, and cross-sectional views illustrate a direction Z. Both the direction X and direction Y are directions parallel with a main surface of the base substrate BS. The direction Z is a direction perpendicular to the main surface of the base substrate BS. The direction Z is perpendicular to the direction X and perpendicular to the direction Y. For example, the direction Y intersects the direction X. The embodiments of the present disclosure are illustrated as an example where the direction X and the direction Y are perpendicular to each other. As shown in the cross-sectional views, the main surface of the base substrate BS is a surface thereof used for preparation of the respective elements. As shown in the cross-sectional views, an upper surface of the base substrate BS is the main surface of the base substrate BS.

For example, in the embodiments of the present disclosure, the direction X may be a first direction and the direction Y may be a second direction. The gate line G1 may be a first gate line, and the gate line G2 may be a second gate line.

It should be noted that the ordinal words of components may be removed or transformed into other ordinal words depending on the order of occurrence.

For the sake of clarity, in the drawings used to describe the embodiments of the present disclosure, the thickness of a layer or region is exaggerated. It can be understood that when an element such as a layer, film, region, or substrate is referred to as being "on" or "under" another element, the element can be "directly" "on" or "under" the other element, or there may be intermediate elements.

In case of no conflict, the features in one embodiment or in different embodiments can be combined.

The foregoing descriptions are only specific implementations of the present disclosure, but are not intended to limit the protection scope of the present disclosure. Any variation or replacement readily figured out by a person skilled in the art within the technical scope disclosed in the present disclosure shall fall within the protection scope of the present disclosure. Therefore, the protection scope of the present disclosure shall be subject to the protection scope of the claims.

## Claims

1. A display panel, comprising:
a plurality of sub-pixels, at least one sub-pixel of the plurality of sub-pixels comprising a pixel circuit and a light-emitting element, the pixel circuit comprising a first transistor, a second transistor and a third transistor, a first electrode of the second transistor being connected to a gate electrode of the first transistor, and a first electrode of the third transistor being connected to a first electrode of the first transistor;
a first gate line connected to a gate electrode of the second transistor; and
a second gate line connected to a gate electrode of the third transistor;
wherein the first gate line extends in a first direction, the second gate line extends in the first direction, the first gate line and the second gate line are spaced apart from each other in a second direction, and the first direction intersects the second direction.

2. The display panel according to claim 1, wherein the first gate line and the second gate line connected to the second transistor and the third transistor of the same sub-pixel respectively are different gate lines.

3. The display panel according to claim 1 or 2, wherein a plurality of first gate lines are provided, a plurality of second gate lines are provided, and the plurality of first gate lines and the plurality of first gate lines are arranged alternately in the second direction.

4. The display panel according to any one of claims 1 to 3, wherein the plurality of sub-pixels comprise a plurality of pixel groups, each pixel group of the plurality of pixel groups comprises two rows and two columns of a total of four sub-pixels, the same first gate line is connected to each of two second transistors in the two rows of sub-pixels, and pixel circuits at positions of the four sub-pixels in the same pixel group are in symmetrical arrangement in layout.

5. The display panel according to claim 4, wherein the pixel circuits at the positions of the four sub-pixels in the same pixel group are in symmetrical arrangement relative to a first axis parallel with the first direction and are in symmetrical arrangement relative to a second axis parallel with the second direction.

6. The display panel according to claim 4 or 5, wherein two second transistors in the two rows of sub-pixels connected to the same first gate line are arranged in the first direction.

7. The display panel according to claim 6, wherein a center connecting line of active layers of the first transistor, the second transistor and the third transistor in each of two sub-pixels of four sub-pixels in the same pixel group forms an obtuse triangle.

8. The display panel according to claim 7, wherein a center connecting line of active layers of the first transistor, the second transistor, and the third transistor in each of another two sub-pixels of the four sub-pixels in the same pixel group forms an acute triangle.

9. The display panel according to claim 4 or 5, wherein two second transistors in the two rows of sub-pixels connected to the same first gate line are arranged in the second direction.

10. The display panel according to claim 9, wherein a center connecting line of active layers of the first transistor, the second transistor, and the third transistor in each of four sub-pixels in the same pixel group forms an obtuse triangle.

11. The display panel according to any one of claims 4 to 10, wherein the four sub-pixels comprise a first sub-pixel, a second sub-pixel, a third sub-pixel, and a fourth sub-pixel,
the first sub-pixel and the third sub-pixel are arranged in the first direction, the fourth sub-pixel and the second sub-pixel are arranged in the first direction, the first sub-pixel and the fourth sub-pixel are arranged in the second direction, and the third sub-pixel and the second sub-pixel are arranged in the second direction.

12. The display panel according to claim 11, wherein the first sub-pixel is a red sub-pixel, the second sub-pixel is a green sub-pixel, the third sub-pixel is a blue sub-pixel, and the fourth sub-pixel is a white sub-pixel.

13. The display panel according to any one of claims 11 and 12, further comprising a data line, a first power line and a sense line, wherein
the data line is connected to a second electrode of the second transistor,
the first power line is connected to a second electrode of the first transistor,
the sense line is connected to the second electrode of the third transistor, and
the data line, the first power line, and the sense line all extend in the second direction.

14. The display panel according to claim 13, wherein a plurality of data lines are provided and comprise a first data line, a second data line, a third data line and a fourth data line, the first data line is connected to the second transistor of the first sub-pixel, the second data line is connected to the second transistor of the second sub-pixel, the third data line is connected to the second transistor of the third sub-pixel, and the fourth data line is connected to the second transistor of the fourth sub-pixel.

15. The display panel according to claim 14, wherein the fourth data line, the first data line, the second data line and the third data line are arranged in the first direction, the sense line is disposed between the first data line and the second data line, and the first data line, the sense line, and the second data line are located between pixel openings of two adjacent columns of sub-pixels.

16. The display panel according to claim 15, wherein the fourth data line and the third data line are adjacent to two first power lines respectively, the fourth data line and the first power line adjacent thereto are located between pixel openings of two adjacent columns of sub-pixels, the third data line and the first power line adjacent thereto are located between pixel openings of two adjacent columns of sub-pixels, thus forming a structure in which one first power line, one fourth data line, one column of pixel openings, one first data line, one sense line, one second data line, another column of pixel openings, one third data line, and the other first power line are sequentially arranged in the first direction.

17. The display panel according to claim 16, wherein the plurality of data lines are not overlapped with one another.

18. The display panel according to claim 14, wherein the first power line and the sense line are located between pixel openings of two adjacent columns of sub-pixels, the first data line and the fourth data line are located between pixel openings of two adjacent columns of sub-pixels, the third data line and the second data line are located between pixel openings of two adjacent columns of sub-pixels, thus forming a structure in which the first data line, the fourth data line, a column of pixel openings, the first power line, the sense line, another column of pixel openings, the third data line, and the second data line are sequentially arranged in the first direction.

19. The display panel according to claim 18, wherein two signal lines extending in the second direction are disposed between pixel openings of every two adjacent columns of sub-pixels.

20. The display panel according to any one of claims 13 to 19, wherein the first power line comprises a power body line and a power connection line, the power body line extends in the second direction, the power connection line extends in the first direction, and the power connection line, the first gate line, and the second gate line are located in the same layer.

21. The display panel according to claim 20, wherein the power connection line is located between the second gate line and the active layer of the first transistor.

22. The display panel according to any one of claims 1 to 21, wherein the light-emitting element is connected to the pixel circuit through a via hole, and the via hole is closer to the first gate line than the active layer of the first transistor in the same sub-pixel.

23. The display panel according to any one of claims 1 to 22, wherein the second gate line comprises a gate body line and a branch, the gate body line extends in the first direction, the branch extends in the second direction, the gate body line and the branch are of an integral structure, and the branch serves as the gate electrode of the third transistor.

24. The display panel according to any one of claims 1 to 23, further comprising a light shield layer, wherein the light shield layer is overlapped with the first transistor.

25. The display panel according to claim 24, wherein the pixel circuit further comprises a storage capacitor, the storage capacitor comprises a first electrode plate and a second electrode plate, the first electrode plate is connected to the gate electrode of the first transistor, the second electrode plate is connected to the first electrode of the first transistor, the first electrode of the third transistor, and a first electrode of the light-emitting element, respectively, and the second electrode plate is connected to the light shield layer.

26. The display panel according to any one of claims 1 to 25, further comprising a color filter layer, wherein the color filter layer is located between the light-emitting element and the pixel circuit, the color filter layer comprises an opening, and the light-emitting element passes through the opening of the color filter layer to be connected to the pixel circuit.

27. A display apparatus, comprising the display panel according to any one of claims 1 to 26.
